# EUROPÄISCHE PATENTSCHRIFT

(11) **EP 3 568 887 B1**
(45) Veröffentlichungstag und Bekanntmachung des Hinweises auf die Patenterteilung: **26.11.2025**
(21) Anmeldenummer: 18703254.5
(22) Anmeldetag: 25.01.2018
(51) Int. Cl.: H01S 5/20, H01S 5/32

(54) **DIODENLASER MIT VERBESSERTEM MODENPROFIL**
DIODE LASER HAVING AN IMPROVED MODE PROFILE
LASER À DIODES À PROFIL DE MODES AMÉLIORÉ

(30) Priorität: 25.01.2017 DE 102017101422
(43) Veröffentlichungstag der Anmeldung: 20.11.2019
(73) Patentinhaber: Ferdinand-Braun-Institut gGmbH, Leibniz-Institut für Höchstfrequenztechnik, 12489 Berlin (DE)
(72) Erfinder: KAUL, Thorben, 12435 Berlin (DE); ERBERT, Götz, 02708 Löbau (DE); CRUMP, Paul, 10245 Berlin (DE)
(74) Vertreter: Gulde & Partner
(86) Internationale Anmeldenummer: PCT/EP2018/051856
(87) Internationale Veröffentlichungsnummer: WO 2018/138209

(56) Entgegenhaltungen:
- US-A1- 2004 013 147
- US-B2- 8 798 109
- HASLER K H ET AL: "Comparative theoretical and experimental studies of two designs of high-power diode lasers", SEMICONDUCTOR SCIENCE AND TECHNOLOGY, IOP PUBLISHING LTD, GB, vol. 29, no. 4, 20 February 2014 (2014-02-20), pages 45010, XP020259881, ISSN: 0268-1242, [retrieved on 20140220], DOI: 10.1088/0268-1242/29/4/045010

## Beschreibung

Die vorliegende Erfindung betrifft einen Diodenlaser mit verbessertem Modenprofil.

### Stand der Technik

Generell besitzen kantenemittierende Laserdioden (Diodenlaser) eine aktive Schicht, welche in Halbleiterschichten eingebettet ist, die sich durch ihre Bandlücken, Brechzahlen und Dotierung voneinander unterscheiden. Die Schichten unterhalb und oberhalb der aktiven Schicht unterscheiden sich dabei insbesondere durch den Leitungstyp (n oder p). Neben der Gewährleistung des Transports von Elektronen und Löchern zur aktiven Schicht, wo sie stimuliert rekombinieren und Laserstrahlung erzeugen, dienen diese Schichten der vertikalen Führung des Laserlichtes. Die der aktiven Schicht benachbarten Schichten werden als Wellenleiterschichten bezeichnet, die diesen Wellenleiterschichten benachbarten Schichten als Mantelschichten. Typischerweise ist die Brechzahl der aktiven Schicht größer als die der Wellenleiterschichten und die Brechzahl der Wellenleiterschichten größer als die der Mantelschichten. Jedoch sind auch andere Konfigurationen möglich (z.B. Vertical ARROW, Photonic Band Crystal).

Insbesondere Breitstreifen-Halbleiterlaser sind aufgrund ihrer Hochleistungsfähigkeit von der Industrie besonders begehrt. Es können stabile optische Leistungen aus einem 100 µm breiten Streifen von über 15 W bei 15 A Diodenstrom aus einer einzelnen Laserdiode erreicht werden. Ein für den Hochleitungsbereich geeigneter Diodenlaser mit geringer Divergenz ist z. B. aus der Druckschrift US 2004/0013147 A1 bekannt.

Leistungskenndaten von Breitstreifenlasern sind bereits von zahlreichen Autoren veröffentlicht worden, wobei insbesondere konventionelle sowie Extrem Doppel-Asymmetrische Strukturen (EDAS) untersucht wurden. Ein solches EDAS-Design ist beispielsweise aus der US 8,798,109 B2 bekannt. Die wesentlichen Vorteile von EDASbasierten Laserdioden sind im Vergleich zu anderen Breitstreifenlaserkonzepten insbesondere ein besonders hoher Wirkungsgrad, geringe optische Verluste und ein geringer ohmscher Widerstand. Das Verhalten von Dioden mit EDAS-Design und 100 µm breitem Streifen wurde bislang jedoch nur bei Raumtemperatur untersucht, die dann für Leistungen größer als ca. 10 W jedoch Konversionseffizienzen aufzeigen, die deutlich oberhalb der von konventionellen Strukturen erreichbaren Konversionseffizienzen liegen, wie in Hasler et al., Semicond. Sci. Technol. 29, p. 045010 (2014) und Crump et al., IEEE J. Sel. Top. Quant. Electron. 19(4), 1501211 (2013) nachzulesen. Es zeigt sich, dass Dioden mit EDAS-Design aufgrund ihres schmalen p-seitigen Wellenleiters (dünner als 150 nm, n-Wellenleiter dicker als 1 µm) einen deutlich geringeren Serienwiderstand (um bis zu 40%) sowie geminderte Verlustmechanismen (z.B. Bandkantenbiegung, Ladungsträgerakkumulation im optischen Wellenleiter und spannungs- und temperaturgetriebene Leckströme) aufweisen.

Um den signifikanten Einfluss der p-leitenden Wellenleiterschicht auf den optischen Verlust und den ohmschen Widerstand zu reduzieren, ist beim EDAS-Design eine zweifache Asymmetrie im Bereich des Wellenleiters vorgesehen, wodurch die Energie der sich ausbildenden (Grund-)Mode zur n-leitenden Seite verlagert wird. Ein Nachteil des EDAS-Designs ist daher jedoch, dass sich das Maximum der Grundmode, aufgrund des schmalen p-Wellenleiters, weg von der aktiven Zone in den n-Bereich verschiebt. Dadurch verringert sich der optische Modeneinschluss innerhalb der aktiven Zone, was zu einer drastischen Erhöhung des Schwellenstroms und zu einer konsequenten Reduzierung der maximalen Konversionseffizienz führt. Zusätzlich, wie in T. Kaul et al., Proc. 25th International Semiconductor Laser Conference (ISLC 2016), Kobe, Japan, Sep. 12-15, p. WD4 (2016) erläutert, ist ein hoher optischer Modeneinschluss auch für die Realisierung von temperaturunempfindlichen Diodenlasern notwendig.

Bisherige Studien betonen, dass man den Modeneinschlussfaktor durch Verschiebung des Quantenfilms in Richtung n-Gebiet oder durch die Verwendung einer Multi-Quantenfilm-Konfiguration steigern kann. Im ersten Fall erhält man nicht die zuvor genannten Vorteile eines EDAS-Designs. Im zweiten Fall kommt es zu einer drastischen Erhöhung der Transparenzstromdichte und als Folge davon zu einer unvermeidbaren Erhöhung des Schwellenstroms und zu einer Reduzierung der Konversionseffizienz, weshalb vertikale Schichtstrukturen mit nur einem Quantenfilm vorteilhaft sind.

### Offenbarung der Erfindung

Es ist daher eine Aufgabe der vorliegenden Erfindung, einen Diodenlaser mit verbessertem Modenprofil anzugeben, welcher die beschriebenen Nachteile des Standes der Technik überwindet. Insbesondere soll ein erfindungsgemäßer Diodenlaser auf einem EDAS-Design mit nur einem Quantenfilm basieren sowie einen hohen optischen Modeneinschluss aufweisen, wobei weder der Quantenfilm in den n-Bereich verschobenen wird noch eine breitere aktive Zone benötigt wird.

Diese Aufgaben werden erfindungsgemäß durch die Merkmale des Patentanspruchs 1 gelöst. Zweckmäßige Ausgestaltungen der Erfindung sind in den Unteransprüchen enthalten.

Ein erfindungsgemäßer Diodenlaser umfasst eine n-leitend ausgebildete erste Mantelschicht, eine n-leitend ausgebildete erste Wellenleiterschicht, die auf der ersten Mantelschicht angeordnet ist, eine aktive Schicht, die zur Strahlungserzeugung geeignet ist und die auf der ersten Wellenleiterschicht angeordnet ist, eine p-leitend ausgebildete zweite Wellenleiterschicht, die auf der aktiven Schicht angeordnet ist, eine p-leitend ausgebildete zweite Mantelschicht, die auf der zweiten Wellenleiterschicht angeordnet ist, wobei zwischen der ersten Wellenleiterschicht und der aktiven Schicht eine n-leitend ausgebildete erste Zwischenschicht als Übergangsbereich ausgebildet ist, und zwischen der zweiten Wellenleiterschicht und der aktiven Schicht eine p-leitend ausgebildete zweite Zwischenschicht als Übergangsbereich ausgebildet ist, wobei die Grenzen zwischen den einzelnen Schichten dadurch bestimmt sind, dass an diesen Stellen der Brechzahlverlauf eine Knickstelle aufweist, wobei es sich bei der ersten Zwischenschicht und, optional, der zweiten Zwischenschicht um eine Gradientenindexschicht (GRIN-Schicht) mit einem stetigen Brechzahlverlauf handelt, und wobei eine maximale Brechzahl der ersten Mantelschicht geringer als eine minimale Brechzahl der erste Wellenleiterschicht, eine maximale Brechzahl der erste Wellenleiterschicht geringer als eine minimale Brechzahl der ersten Zwischenschicht, eine maximale Brechzahl der ersten Zwischenschicht geringer als eine minimale Brechzahl der aktiven Schicht, eine minimale Brechzahl der aktiven Schicht höher als eine maximale Brechzahl der zweiten Zwischenschicht, eine minimale Brechzahl der zweiten Zwischenschicht höher als eine maximale Brechzahl der zweiten Wellenleiterschicht und eine minimale Brechzahl der zweiten Wellenleiterschicht höher als eine maximale Brechzahl der zweiten Mantelschicht ist. Dabei ist der erfindungsgemäße Diodenlaser dadurch gekennzeichnet, dass ein Asymmetrie-Verhältnis aus der Dicke der ersten Zwischenschicht zur Summe aus der Dicke der ersten Zwischenschicht und der Dicke der zweiten Zwischenschicht von größer als 0,5 derart gewählt ist, dass das Maximum der Modenintensität einer geführten Grundmode innerhalb der ersten Zwischenschicht lokalisiert ist. Eine nicht von den Ansprüchen umfasste weitere Variante ist die Verwendung eines Asymmetrie-Verhältnisses von kleiner als 0,5, was einen kleineren vertikalen Fernfeldwinkel ohne eine Variation der Wellenleiterdicke ermöglicht.

Erfindungsgemäß handelt es sich bei der ersten Zwischenschicht um eine GRIN-Schicht. In einer ersten Ausführungsform kann es sich bei der zweiten p-leitenden Zwischenschicht um eine GRIN-Schicht handeln. In einer zweiten Ausführungsform kann es sich bei der zweiten p-leitenden Zwischenschicht um eine Schicht mit konstanter Brechzahl bzw. Materialkomposition handeln.

In einer bevorzugten Ausführungsvariante beträgt die Schichtdicke der zweiten Wellenleiterschicht zwischen 3 nm und 350 nm, da bei Schichtdicken größer als 3 nm eine Elektronenwelle in der aktiven Schicht effizient von der Mantelschicht ferngehalten werden kann. In einer besonders bevorzugten Ausführungsvariante beträgt die Schichtdicke der zweiten Wellenleiterschicht zwischen 5 nm und 350 nm, bevorzugter zwischen 5 nm und 150 nm, bevorzugter zwischen 5 nm und 100 nm, bevorzugter zwischen 5 nm und 60 nm, und noch bevorzugter zwischen 5 nm und 30 nm.

Als Übergangsbereich wird ein Bereich zwischen zwei Schichten bezeichnet, in dem die lokalen Brechzahlen an den einander zugewandten Rändern der beiden Schichten aufeinander angepasst werden (eine entsprechende Zwischenschicht kann auch als Brechzahlanpassungsschicht bezeichnet werden). Bei voneinander abweichenden Brechzahlen an den besagten Rändern findet innerhalb des Übergangsbereichs vorzugsweise ein stetiger Übergang (z.B. linearer räumlicher Brechzahlverlauf) zwischen diesen Brechzahlen statt.

Vorzugsweise handelt es sich bei einem Übergangsbereich um eine GRIN-Schicht.

Als GRIN-Schicht (GRIN - Gradient Index) wird dabei eine Schicht bezeichnet, deren Brechzahl entlang der Schichtdicke einen Gradienten aufweist. Insbesondere handelt es sich hierbei um Schichten, bei denen die Brechzahl von einem ersten Wert an einer ersten Seite der Schicht zu einem zweiten Wert ungleich dem ersten Wert an einer der ersten Seite gegenüberliegenden Seite der Schicht (quer zur Lichtausbreitungsrichtung) ansteigt oder abfällt. Dieser Übergang ist stetig. Vorzugsweise besteht zwischen Brechzahl und Schichtdicke ein monotoner Zusammenhang, bevorzugter ein polynomialer oder ein exponentieller Zusammenhang und noch bevorzugter ein linearer Zusammenhang.

Vorzugsweise enthält mindestens eine der beiden Wellenleiterschichten einen Brechzahlgradienten. Im Falle einer oder mehrerer Wellenleiterschichten mit einem Brechzahlgradienten, wird zur Berechnung der Differenz zwischen der Brechzahl einer Wellenleiterschicht und der Brechzahl einer dazugehörigen Mantelschicht stets der größte Betrag der Brechzahl in der jeweiligen Schicht (d.h. der Schicht mit dem Brechzahlgradienten) herangezogen. Unter einer Schicht (Wellenleiterschicht) mit Brechzahlgradienten wird gemäß der vorliegenden Erfindung eine Schicht (Wellenleiterschicht) verstanden, deren Brechzahl entlang der Schichtdickenachse (quer zur Lichtausbreitungsrichtung) variiert. Vorzugsweise variiert die Brechzahl von einem ersten Wert an der ersten Grenzfläche (zur Mantelschicht) zu einem zweiten Wert an der zweiten Grenzfläche (zur Zwischenschicht).

Alle Brechzahlen beziehen sich auf die Zentralwellenlänge der von der aktiven Schicht emittierten bzw. verstärkten Strahlung. Die Zentralwellenlänge der von der aktiven Schicht emittierten Strahlung liegt vorzugsweise zwischen 380 nm und 10 µm, bevorzugter zwischen 380 nm und 1200 nm, bevorzugter zwischen 700 nm und 1000 nm und noch bevorzugter zwischen 900 nm und 1000 nm.

Die Idee der vorliegenden Erfindung besteht darin, dem Übergangsbereich in der Nähe der aktiven Schicht, insbesondere in der Nähe eines einzelnen Quantenfilms als aktiver Schicht, eine zusätzliche asymmetrische Komponente zu geben. Dadurch lassen sich die Modeneigenschaften und insbesondere das Modenprofil bzw. die räumliche Lage des Modenmaximums in Bezug zur aktiven Schicht gezielt beeinflussen und steuern. Insbesondere wird hierzu eine dreifache (Tripel-)Asymmetrie im Schichtaufbau realisiert (asymmetrische n- und p-Wellenleiterschichten, asymmetrische n- und p-Mantelschichten sowie asymmetrische n-, p-Zwischenschichten).

Diese Methode der Modenbeeinflussung ist besonders interessant für Laserdioden mit EDAS-Design, da in symmetrischen Strukturen die Einbringung einer solchen asymmetrischen Komponente in den Übergangsbereichen aufgrund der zentrierten Modenführung weniger starken Einfluss auf das Diodenverhalten zeigt. Ein um eine solche zusätzliche asymmetrische Komponente erweitertes EDAS-Design wird im Folgenden auch als Extrem Tripel-Asymmetrische Struktur (ETAS) bezeichnet. Insbesondere eignet sich die Idee der vorliegenden Erfindung dazu, bei einer Laserdiode im EDAS-Design den p-Wellenleiter unberührt zu lassen und durch die zusätzliche asymmetrische Komponente in den Übergangsbereichen zur aktiven Schicht den Modeneinschluss in der aktiven Schicht zu modifizieren. Die Anwendung der erfindungsgemäßen asymmetrischen Auslegung der n- und p-seitigen Übergangsbereiche zwischen den Wellenleiterschichten und der aktiven Schicht ist jedoch nicht auf Laserdioden mit EDAS-Design beschränkt.

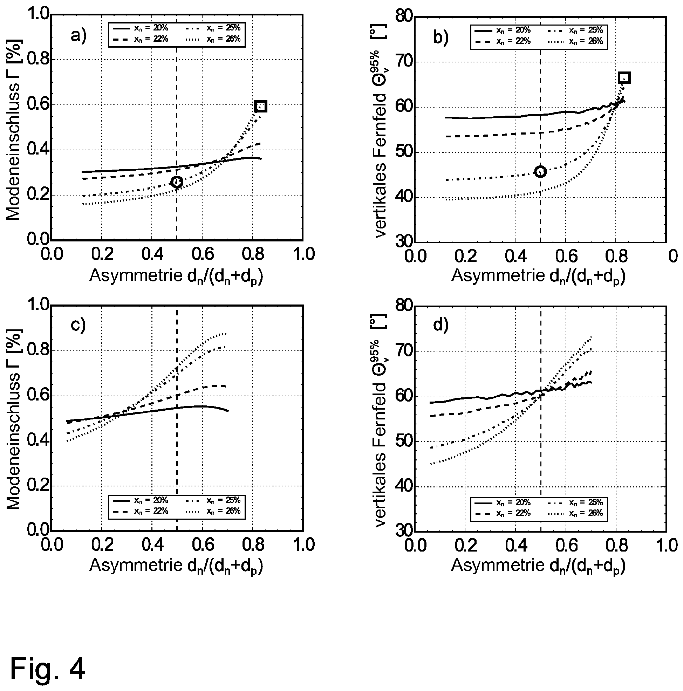

Bei einer Laserdiode mit ETAS-Design verlagert sich für eine Asymmetrie, bei der das Verhältnis aus der Dicke der ersten Zwischenschicht zur Summe aus der Dicke der ersten Zwischenschicht und der Dicke der zweiten Zwischenschicht erfindungsgemäß größer als 0,5 ist, die geführte Grundmode in Richtung der aktiven Schicht bzw. des Quantenfilms. Dadurch erhöhen sich die optische Leistungsdichte der Grundmode im Nahfeld sowie der modale Einschluss in der aktiven Schicht (Modeneinschluss Γ). Der Fig. 4 a) ist beispielsweise zu entnehmen, dass der Modeneinschluss Γ deutlich erhöht werden kann, wenn man die Dicke der n-seitigen Zwischenschicht bei einer gleich bleibenden Dicke der p-seitigen Zwischenschicht erhöht. In einer exemplarischen herkömmliche EDAS-Struktur mit einzelnen Quantenfilmen und symmetrischen GRIN-Zwischenschichten ist Γ = 0,2% (siehe M. Winterfeldt et al., Proc. SPIE 9733, 97330O (2016)). Insbesondere lässt sich mit dieser ETAS-Technik für dieses Beispiel der Modeneinschluss Γ von 0,2% auf 0,6% nahezu verdreifachen, ohne dass dabei das p-Gebiet einer konventionellen EDAS-Laserdiode abgeändert werden muss. Somit können alle positiven Eigenschaften des herkömmlichen EDAS-Designs erhalten bleiben. Eine weitere Erkenntnis ist die, dass man mit einem asymmetrischen ETAS-Aufbau (siehe Fig. 4 a) gegenüber Fig. 4c)) mit einer Schichtdicke der zweiten GRIN-Zwischenschicht von 70 nm einen nahezu identischen Modeneinschluss wie mit einem mehr als doppelt so breiten (150 nm) symmetrischen EDAS-Aufbau erreichen kann. Diese Strategie ermöglicht deutlich gesteigerte Konversionseffizienzen bei hohen optischen Leistungen aus Halbleiterlasern mit ETAS-Design zu erzeugen und ist von essentieller Natur für den Markt der hocheffizienten Hochleistungslaserdioden. Mithilfe der vorliegenden Erfindung wird es möglich, den Einsatz von Laserdioden mit EDAS-Design auf den Hochtemperaturbereich zu erweitern.

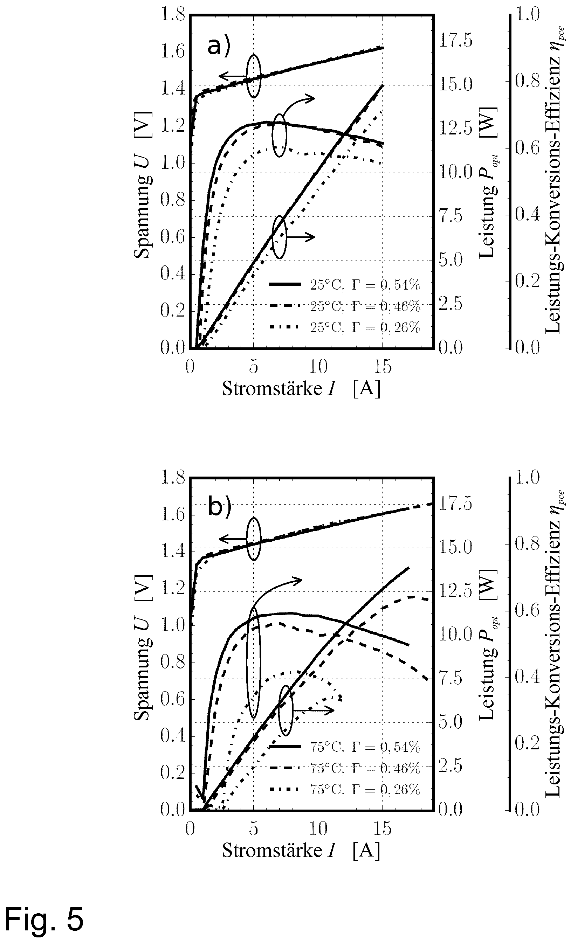

Für nicht von den Ansprüchen umfasste Laserdioden mit ETAS-Design, bei denen das Verhältnis aus der Dicke der ersten Zwischenschicht zur Summe aus der Dicke der ersten Zwischenschicht und der Dicke der zweiten Zwischenschicht kleiner als 0,5 ist, erreicht man durch die zusätzliche asymmetrische Komponente in den Übergangsbereichen zur aktiven Schicht eine Verlagerung des Modenmaximums in Richtung des n-Gebietes, so dass sich eine Verbreiterung des emittierten Nahfeldprofils und eine daraus resultierende Verringerung des vertikales Fernfeldprofils ergibt. Bei gleichbleibender Dicke des p-seitigen Wellenleiters lässt sich durch die geringere Strahlungsdichte an der Frontfacette der Laserdiode auch eine erhöhte Ausfallsleistung aufgrund von COMD (catastrophic optical mirror damage) erreichen, wie in D. Botez, Appl. Phys. Lett. 74(21), 3102 (1999) gezeigt. Weiterhin lassen sich dadurch die Fernfeldwinkel verkleinern, wie besonders in Figur 4 d) zu erkennen ist, wo durch eine Reduzierung der Asymmetrie ohne eine Änderung der p-Wellenleiterdicke eine Reduzierung des Fernfeldes um mehr als 10° möglich ist. Dies geschieht zwar auf Kosten des Modeneinschlusses, was jedoch zum Beispiel für Anwendungen im Bereich niedriger Betriebstemperaturen auch durchaus von Vorteil sein kann. Aus Fig. 5 a) kann zudem entnommen werden, dass die Leistungskurven für die Modeneinschlüsse Γ = 0,46% und Γ = 0,54% sehr ähnlich sind, weshalb hier bei einer Verbesserung des Fernfeldes keine wesentlichen Einbußen in der Leistungscharakteristik der Laserdioden in Kauf genommen werden müssen.

Durch das ETAS-Design mit Tripel-Asymmetrie, beispielsweise mit asymmetrischen GRIN-Zwischenschichten, wird eine neue Designfreiheit zur Verfügung gestellt, die entweder für einen erhöhten Konversionswirkungsgrad und reduzierte Temperaturempfindlichkeit (aufgrund eines erhöhten Modeneinschlusses) oder für eine größere nutzbare Leistung aufgrund höherer COMD-Leistung (entsprechend dem verringerten Modeneinschluss) und geringerer Divergenz verwendet werden kann.

Erfindungsgemäß ist die Summe der Schichtdicke der ersten Wellenleiterschicht und der Schichtdicke der zweiten Wellenleiterschicht größer als 1 µm, bevorzugter größer als 1,5 µm und noch bevorzugter größer als 2 µm. Vorzugsweise ist die Summe der Schichtdicke der ersten Wellenleiterschicht und der Schichtdicke der zweiten Wellenleiterschicht kleiner als 10 µm, bevorzugter kleiner als 5 µm, bevorzugter kleiner als 4 µm und noch bevorzugter kleiner als 3 µm. Durch diese Ausgestaltung wird es ermöglicht, für die Grundmode ein vertikales Fernfeld von kleiner als 60° zu erreichen, innerhalb dessen 95% der Strahlungsleistung eingeschlossen sind bzw. abgestrahlt werden (FF95%). Weiterhin führt ein geringer Anteil der Grundmode innerhalb der p-leitenden Wellenleiterschicht (vorzugsweise < 15%, beispielsweise bei einer 150 nm dicken p-leitenden Wellenleiterschicht und bei 1,15 µm Gesamtdicke) zu einem möglichst geringen optischen Absorptionsverlust.

Vorzugsweise ist die Schichtdicke der zweiten Wellenleiterschicht kleiner als 500 nm, bevorzugter kleiner als 350 nm, bevorzugter kleiner als 250 nm, bevorzugter kleiner als 150 nm, bevorzugter kleiner als 100 nm und noch bevorzugter kleiner als 50 nm.

Vorzugsweise ist die Schichtdicke der zweiten Wellenleiterschicht größer als 5 nm, bevorzugter größer als 10 nm und noch bevorzugter größer als 25 nm.

Vorzugsweise ist die Schichtdicke der ersten Zwischenschicht kleiner als 500 nm, bevorzugter kleiner als 350 nm, bevorzugter kleiner als 300 nm, bevorzugter kleiner als 200 nm, bevorzugter kleiner als 150 nm, bevorzugt kleiner als 75 nm und noch bevorzugt kleiner als 30 nm. Vorzugsweise ist die Schichtdicke der ersten Zwischenschicht größer als 5 nm, bevorzugter größer als 10 nm und noch bevorzugter größer als 25 nm. Vorzugsweise ist die Schichtdicke der zweiten Zwischenschicht kleiner als 500 nm, bevorzugter kleiner als 350 nm und bevorzugter kleiner als 300 nm, bevorzugter kleiner als 150 nm und noch bevorzugt kleiner als 75 nm. Vorzugsweise ist die Schichtdicke der zweiten Zwischenschicht größer als 5 nm, bevorzugter größer als 10 nm und noch bevorzugter größer als 25 nm.

Durch eine geringe Schichtdicke der zweiten Wellenleiterschicht können ein geringer optischer Verlust und ein geringer ohmscher Widerstand erzielt werden. Erfindungsgemäß beträgt die Differenz der maximalen Brechzahl der ersten Wellenleiterschicht und der Brechzahl der ersten Mantelschicht zwischen 0,04 und 0,01 Hierdurch kann vorteilhafterweise erreicht werden, dass Obermoden unterdrückt bzw. vollständig eliminiert werden. Die Differenz der Brechzahlen muss so groß sein, dass im aktiven Betrieb thermisch und elektronisch induzierte Brechzahländerungen, deren Größe typischerweise kleiner als 0,01 ist, keinen Einfluss auf die Lasereigenschaften haben. Als Folge ist die Grundmode stabil gegenüber Temperatur- oder Ladungsträgereffekten (d.h. hauptsächlich von Wellenleiter- und Mantelschichten definiert). In einer besonders bevorzugten Ausführungsvariante liegt die Differenz der maximalen Brechzahl der ersten Wellenleiterschicht und der Brechzahl der ersten Mantelschicht zwischen 0,04 und 0,015. Ebenfalls vorzugsweise ist die Differenz der maximalen Brechzahl der ersten Wellenleiterschicht und der Brechzahl der ersten Mantelschicht kleiner oder gleich 0,035. Weiterhin bevorzugt ist die Differenz der maximalen Brechzahl der ersten Wellenleiterschicht und der Brechzahl der ersten Mantelschicht größer oder gleich 0,015. Vorzugsweise fällt innerhalb der ersten Zwischenschicht die Brechzahl, von der aktiven Schicht ausgehend, in Richtung der ersten Wellenleiterschicht um mindestens 0,03 oder um 30% der Differenz zwischen der maximalen Brechzahl der ersten Zwischenschicht und der minimalen Brechzahl der ersten Wellenleiterschicht ab. Die n-seitige Zwischenschicht überbrückt somit mindestens 0,03 oder 30% des Brechzahlsprungs zwischen der maximalen Brechzahl der ersten Zwischenschicht und der minimalen Brechzahl der ersten Wellenleiterschicht. Bevorzugter fällt innerhalb der ersten Zwischenschicht die Brechzahl um mindestens 0,05 oder um 50% der besagten Differenz und noch bevorzugter 0,07 oder um 70% der besagten Differenz. Insbesondere kann es sich bei dem abfallenden Brechzahlprofil innerhalb der ersten Zwischenschicht um eine kontinuierlich abfallende Funktion der Schichtdicke handeln. Vorzugsweise fällt die Brechzahl innerhalb der ersten Zwischenschicht monoton als Funktion der Schichtdicke von der maximalen Brechzahl der aktiven Schicht zur minimalen Brechzahl der ersten Wellenleiterschicht ab. Vorzugsweise befindet sich die minimale Brechzahl der ersten Wellenleiterschicht an der Grenze zur ersten Mantelschicht.

Vorzugsweise fällt innerhalb der zweiten Zwischenschicht die Brechzahl, von der aktiven Schicht ausgehend, in Richtung der zweiten Wellenleiterschicht nicht ab, sondern weist in der gesamten zweiten Zwischenschicht einen konstanten Wert auf. In einer alternativen Ausführungsform, fällt innerhalb der zweiten Zwischenschicht die Brechzahl um mindestens 9% der Differenz zwischen der maximalen Brechzahl der zweiten Zwischenschicht und der minimalen Brechzahl der zweiten Wellenleiterschicht ab. Die p-seitige Zwischenschicht überbrückt somit mindestens 9% des Brechzahlsprungs zwischen der maximalen Brechzahl der zweiten Zwischenschicht und der minimalen Brechzahl der zweiten Wellenleiterschicht. Insbesondere kann es sich bei dem abfallenden Brechzahlprofil innerhalb der zweiten Zwischenschicht um eine kontinuierlich abfallende Funktion der Schichtdicke handeln. Vorzugsweise fällt die Brechzahl innerhalb der zweiten Zwischenschicht kontinuierlich als Funktion der Schichtdicke von der maximalen Brechzahl der aktiven Schicht zur minimalen Brechzahl der zweiten Wellenleiterschicht ab. Vorzugsweise befindet sich die minimale Brechzahl der ersten Wellenleiterschicht an der Grenze zur zweiten Mantelschicht.

Vorzugsweise sind die Wellenleiterschichten und die Mantelschichten uniform ausgebildet. Vorzugsweise erstreckt sich die Uniformität über ihre gesamte Länge, die sich zwischen den Facetten der Laserdiode befindet, noch bevorzugter über ihre gesamte Ausdehnung. Uniformität im Sinne der vorliegenden Anmeldung bedeutet, dass die Schichtparameter (wie chemische Zusammensetzung, Dotierung, Schichtdicke, Brechzahl) über die genannte Erstreckung relativ gesehen (Maximum zu Minimum) weniger als 10%, bevorzugter weniger als 5%, bevorzugter weniger als 1% voneinander abweichen.

Bevorzugtes Material der ersten Mantelschicht ist AlₓGa₁₋ₓAs, bevorzugter liegt die Materialkomposition zwischen Al_{0.28}Ga_{0.72}As und Al_{0.32}Ga_{0.68}As. Die erste Mantelschicht weist vorzugsweise eine Schichtdicke zwischen 0,5 µm und 4 µm auf. Bevorzugtes Material der ersten Wellenleiterschicht ist AlₓGa₁₋ₓAs, bevorzugter liegt die Materialkomposition zwischen Al_{0.10}Ga_{0.90}As und Al_{0.32}Ga_{0.68}As. Die erste Wellenleiterschicht weist vorzugsweise eine Schichtdicke zwischen 0,5 µm und 3 µm auf. Als Materialien der ersten Mantelschicht und der ersten Wellenleiterschicht kommen alle Verbindungshalbleiter bestehend aus Elementen der 3. Hauptgruppe (AI, Ga, In) und 5. Hauptgruppe (N, P, As und Sb) des Periodensystems der Elemente in Frage, welche die gewünschte Differenz der Brechzahl der ersten Wellenleiterschicht und der Brechzahl der ersten Mantelschicht erzeugen. Vorzugsweise sind die erste Wellenleiterschicht und die zweite Wellenleiterschicht aus dem gleichen Material ausgebildet. Die Brechzahl der ersten Mantelschicht ist vorzugsweise kleiner als die Brechzahl der ersten Wellenleiterschicht. Die Brechzahl der zweiten Mantelschicht ist vorzugsweise kleiner als die Brechzahl der zweiten Wellenleiterschicht.

Bevorzugtes Material der aktiven Schicht ist ein InGaAs MQW (multi quantum well oder auch Vielfachquantentopf), bevorzugter ein InGaAs DQW (double quantum well oder auch Doppelquantentopf) und noch bevorzugter ein InGaAs SQW (single quantum well oder auch Einzelquantentopf). Als mögliche Materialien der aktiven Schicht kommen alle Verbindungshalbleiter bestehend aus Elementen der 3. Hauptgruppe (AI, Ga, In) und 5. Hauptgruppe (N, P, As und Sb) des Periodensystems der Elemente in Frage, z.B. als GaAsP, InGaAsP, AllnGaAs, InGaAsNSb. Bevorzugtes Material der zweiten Wellenleiterschicht ist AlₓGa₁₋ₓAs, bevorzugt mit einem möglichst kleinem molaren Al-Gehalt x für einen minimalen elektrischen Widerstand; für eine Wellenlänge von 940 nm an der Grenzschicht zwischen der zweiten Zwischenschicht und der zweiten Wellenleiterschicht bevorzugt kleiner 0,4, bevorzugter kleiner 0,3 und noch bevorzugter kleiner oder gleich 0,25 und an der Grenzschicht zwischen der zweiten Wellenleiterschicht und der zweiten Mantelschicht bevorzugt kleiner 0,95, bevorzugter kleiner 0,9 und noch bevorzugter kleiner 0,85.

Vorzugsweise weist die aktive Schicht eine (Gesamt-)Schichtdicke kleiner als 80 nm, bevorzugter kleiner als 60 nm, bevorzugter kleiner als 40 nm und noch bevorzugter kleiner als 20 nm auf.

Vorzugsweise weist die aktive Schicht mindestens einen Quantentopf ohne Barriereschichten auf. In einer alternativen bevorzugten Variante weist die aktive Schicht mindestens eine Topfschicht und mindestens zwei Barriereschichten auf. Vorzugsweise beträgt die Schichtdicke der mindestens einen Topf enthaltenden Schicht zwischen 1 nm und 25 nm, bevorzugter zwischen 5 und 20 nm. Vorzugsweise sind die Schichtdicken der mindestens einen Topf enthaltenden Schicht uniform und gleich. Vorzugsweise sind die Schichtdicken der optional vorhandenen Barriereschichten uniform und gleich. Die Anzahl der Topfschichten beträgt vorzugsweise kleiner 15, bevorzugter kleiner 10, bevorzugter kleiner 5 und noch bevorzugter kleiner 3. Vorzugsweise beträgt die Gesamtschichtdicke der aktiven Schicht (mit allen Topf- und Barriereschichten) kleiner als 80 nm, bevorzugter kleiner als 60 nm, bevorzugter kleiner als 40 nm und noch bevorzugter kleiner als 20 nm.

Vorzugsweise ist die aktive Schicht uniform ausgebildet. Vorzugsweise erstreckt sich die Uniformität der aktiven Schichte über ihre gesamte Länge, die sich zwischen den Facetten der Laserdiode befindet, noch bevorzugter über ihre gesamte Ausdehnung. Uniformität der aktiven Schicht im Sinne der vorliegenden Anmeldung bedeutet, dass die Schichtparameter (wie chemische Zusammensetzung, Dotierung, Schichtdicke, Brechzahl) über die genannte Erstreckung relativ gesehen (Maximum zu Minimum) weniger als 10%, bevorzugter weniger als 5%, bevorzugter weniger als 1 %, und noch bevorzugter gar nicht voneinander abweichen.

Vorzugsweise erstreckt sich die aktive Schicht über den gesamten Bereich zwischen einer Reflexionsfacette und einer Austrittsfacette. Vorzugsweise kontaktiert eine aktive Schicht sowohl die Reflexionsfacette als auch die Austrittsfacette direkt. Die aktive Schicht kann auch von den Facetten in einem Bereich zwischen 0 µm und 500 µm beabstandet werden, beispielsweise durch Nutzung von Implantation, Intermixing oder Überwachsen, um einen Ausfall des Lasers durch Zerstörung der Facette(n) zu verhindern.

Vorzugsweise sind die Oberflächen der Reflexionsfacette und der Austrittsfacette planar ausgebildet. Vorzugsweise sind die Oberflächen der Reflexionsfacette und der Austrittsfacette parallel zueinander angeordnet. Vorzugsweise verlaufen die Längsachse der ersten Wellenleiterschicht und die Längsachse der zweiten Wellenleiterschicht senkrecht zu den Oberflächen der Reflexionsfacette und der Austrittsfacette. Vorzugsweise ist ein Rippenwellenleiter zur Kontrolle des lateralen Fernfeldes vorgesehen.

Vorzugsweise bestehen die erste Zwischenschicht und die zweiten Zwischenschicht aus AlₓGa₁₋ₓAs. Vorzugsweise hat dabei der molare Al-Gehalt x der ersten Zwischenschicht an der Grenzfläche zwischen der ersten Zwischenschicht und der aktiven Schicht einen Wert von größer oder gleich 0, bevorzugter größer 0,05 und noch bevorzugter größer 0,1. Ebenfalls bevorzugt ist, dass der molare Al-Gehalt x der ersten Zwischenschicht an der Grenzfläche zwischen der ersten Wellenleiterschicht und der ersten Zwischenschicht größer als 0,05, bevorzugter größer als 0,1, bevorzugter größer als 0,15 und noch bevorzugter größer als 0,2 ist. Beispielsweise ergibt sich für die Differenz aus der maximalen Brechzahl einer ersten Wellenleiterschicht (exemplarisch aus Al_{0,25}Ga_{0,75}As) und der maximalen Brechzahl einer ersten Zwischenschicht (exemplarisch aus Al_{0,15}Ga_{0,85}As) an der Grenzfläche zwischen der ersten Wellenleiterschicht und der aktiven Schicht zu 0,07. Besonders bevorzugt ist dieser Differenzwert größer als 0,03, bevorzugter größer als 0,05 und noch bevorzugter größer als 0,07.

Die Ausbildung eines Brechzahlgradienten in mindestens einer der Wellenleiterschichten, vorzugsweise der ersten Wellenleiterschicht, ist vorteilhaft, weil dies zu einem günstigen Intensitätsprofil der Grundmode und damit zu einer niedrigen Laserschwelle führt. Aufgrund des erfindungsgemäßen Designs ist es möglich, die Intensität der Grundmode innerhalb des Quantenfilms festzulegen, ohne dass dafür die Dicke der p-Zwischenschicht oder die Dicke der Wellenleiterschichten nachteilig angepasst werden müssen. Liegt die Grundmode jedoch zu weit innerhalb einer der Wellenleiterschichten, würde die Laserschwelle stark ansteigen, so dass die Ausbildung eines Brechzahlgradienten zu einer günstigeren Positionierung der Grundmode im Wellenleiter führen kann.

In einer besonders bevorzugten Ausführungsvariante weisen die erste Wellenleiterschicht und die zweite Wellenleiterschicht einen Brechzahlgradienten (z.B. durch Variation des Aluminiumgehalts entlang der Schichtdicke) auf, wobei im Fall von AlₓGa₁₋ₓAs Wellenleiterschichten der molare Al-Gehalt x der zweiten Wellenleiterschicht zwischen 10% und 95% und bei der ersten Wellenleiterschicht zwischen 10% und 32% variiert werden kann. Vorzugsweise ändert sich die Brechzahl im Falle eines Brechzahlgradienten linear von einer zur anderen Seite.

Vorzugsweise ist die Brechzahl einer Wellenleiterschicht an der Grenzfläche zur Mantelschicht geringer als an der Grenzfläche zur Zwischenschicht. Vorzugsweise variiert die Brechzahl einer Wellenleiterschicht stufenlos von der Grenzfläche zur Mantelschicht zur Grenzfläche zur Zwischenschicht. Vorzugsweise wird der Brechzahlgradient durch ein materialspezifisches Kompositionsprofil im Halbleiter erzeugt. Zum Beispiel kann im Materialsystem AlₓGa₁₋ₓAs der Brechzahlgradient durch einen Gradienten des molaren Al-Gehaltes x erzeugt werden. Sofern die zweite Wellenleiterschicht ein Kompositionsprofil aufweist, wird vorzugsweise AlₓGa₁₋ₓAs, mit einem molaren Al-Gehalt zwischen Al_{0.15}Ga_{0.85}As und Al_{0.85}Ga_{0.15}As verwendet.

Vorzugsweise ist der erfindungsgemäße Diodenlaser für den Dauerstrichbetrieb ausgebildet. Vorzugsweise ist eine elektrische Ansteuerung für den Diodenlaser derart ausgebildet, dass der Diodenlaser im Dauerstrichbetrieb arbeitet. Vorzugsweise ist der Diodenlaser als kantenemittierender Diodenlaser ausgebildet. Vorzugsweise ist der Diodenlaser als optischer Verstärker ausgebildet.

Vorzugsweise ist ein Trägersubstrat vorgesehen, auf dem die genannte Schichtstruktur aufgebaut ist. Vorzugsweise sind die n-leitenden Schichten auf der Seite der aktiven Schicht angeordnet, die dem Trägersubstrat zugewandt ist, wohingegen die p-leitenden Schichten auf der Seite der aktiven Schicht angeordnet sind, die dem Trägersubstrat abgewandt ist. Vorzugsweise weist der Diodenlaser Kontaktschichten zur Injektion von Ladungsträgern auf.

### Kurzbeschreibung der Zeichnungen

Die Erfindung wird nachfolgend in Ausführungsbeispielen anhand der zugehörigen Zeichnung erläutert. Es zeigen:
- Fig. 1: die Brechzahlverteilung entlang der Schichten einer herkömmlichen EDAS-Laserdiode nach dem Stand der Technik sowie die dazugehörige vertikale Verteilung der Modenintensität in der Laserdiode,
- Fig. 2A: die Brechzahlverteilung entlang der Schichten einer ersten Ausführungsform einer erfindungsgemäßen ETAS-Laserdiode sowie die dazugehörige vertikale Verteilung der Modenintensität in der Laserdiode,
- Fig. 2B: die Brechzahlverteilung entlang der Schichten einer zweiten Ausführungsform einer erfindungsgemäßen ETAS-Laserdiode sowie die dazugehörige vertikale Verteilung der Modenintensität in der Laserdiode,
- Fig. 3A: eine erfindungsgemäße Laserdiode in schematischer perspektivischer Darstellung,
- Fig. 3B: die erfindungsgemäße Laserdiode aus Fig. 2A in schematischer geschnittener Darstellung entlang einer Achse quer zur Lichtausbreitungsrichtung,
- Fig. 3C: die erfindungsgemäße Laserdiode aus Fig. 2A in schematischer geschnittener Darstellung entlang einer Achse parallel zur Lichtausbreitungsrichtung,
- Fig. 4: die simulierten Abhängigkeiten des Modeneinschlusses (a, c) und des vertikalen Fernfeldes (b, d) von der Stärke des Asymmetrie-Verhältnisses und der Schichtdicke der zweiten Wellenleiterschicht, und
- Fig. 5: die Leistungs-Spannungs-Strom-Charakteristik dreier vergleichbarer Halbleiterlaserdioden mit verschiedenen Ausführungsformen eines erfindungsgemäßen ETAS-Designs bei 25°C (a) und bei 75°C (b).

### Ausführliche Beschreibung der Zeichnungen

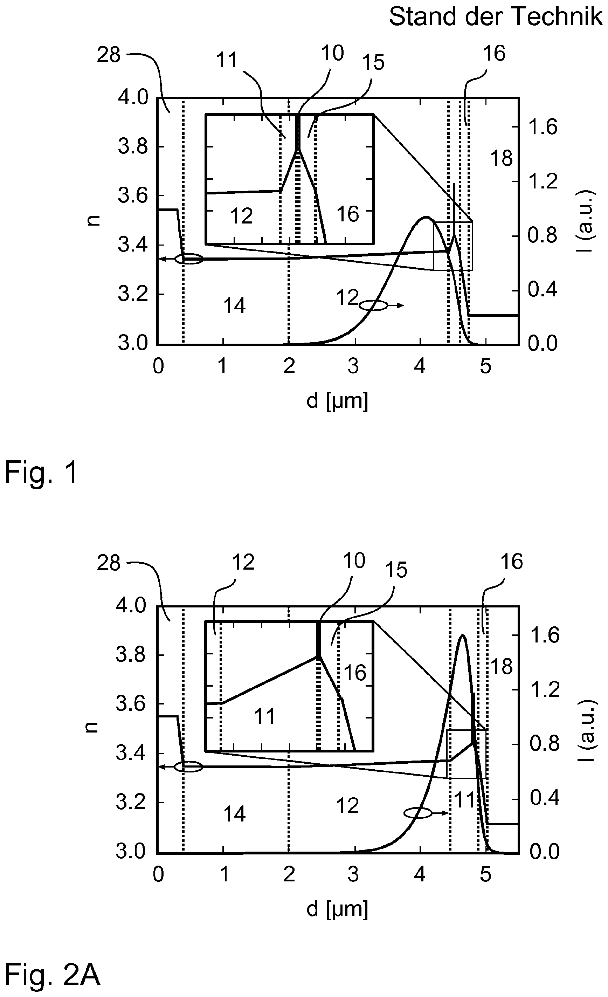

Fig. 1 zeigt die Brechzahlverteilung entlang der Schichten einer herkömmlichen EDAS-Laserdiode nach dem Stand der Technik sowie die dazugehörige vertikale Verteilung der Modenintensität in der Laserdiode. Die Laserdiode weist einen Schichtaufbau mit einer n-leitenden ersten Mantelschicht 14, einer darauf angeordneten, n-leitenden ersten Wellenleiterschicht 12, einer darauf angeordneten, n-leitenden ersten Zwischenschicht 11 (GRIN-Schicht), einer darauf angeordneten aktiven Schicht 10, einer darauf angeordneten, p-leitenden zweiten Zwischenschicht 15 (GRIN-Schicht), einer darauf angeordneten, p-leitenden zweiten Wellenleiterschicht 16 und einer darauf angeordneten, p-leitenden zweiten Mantelschicht 18 auf. Die genannten Schichten sind auf einem Substrat 28 angeordnet. Die jeweiligen Dicke der ersten Zwischenschicht 11 und der zweiten Zwischenschicht 15 sind gleich groß, d.h. die aktive Schicht 10 ist mittig zwischen den eingezeichneten Grenzflächen der ersten Zwischenschicht 11 mit der ersten Wellenleiterschicht 12 und der zweiten Zwischenschicht 15 mit der zweiten Wellenleiterschicht 16 angeordnet. Insbesondere ist, wie bei allen EDAS-Laserdioden nach dem Stand der Technik, das Asymmetrie-Verhältnis aus der Dicke der ersten Zwischenschicht 11 zur Summe aus der Dicke der ersten Zwischenschicht 11 und der Dicke der zweiten Zwischenschicht 15 gleich 0,5.

Das Maximum der Intensität der eingezeichneten Grundmode befindet sich bei dem gezeigten EDAS-Design deutlich außerhalb der aktiven Schicht (d.h. geringer Modeneinschluss) und weit innerhalb des ersten Wellenleiterbereichs 12. Mit der aktiven Schicht 10 kann die Mode nur über ihre steil abfallende p-seitige Flanke bei geringer Intensität und kleinem Modeüberlapp wechselwirken.

Fig. 2A zeigt die Brechzahlverteilung entlang der Schichten einer ersten Ausführungsform einer erfindungsgemäßen ETAS-Laserdiode sowie die dazugehörige vertikale Verteilung der Modenintensität in der Laserdiode. Der dargestellte Schichtaufbau entspricht im Wesentlichen dem in Fig. 1 gezeigten Aufbau. Die jeweiligen Bezugszeichen gelten entsprechend. Im Gegensatz zur Darstellung in Fig. 1 wurde bei der gezeigten Laserdiode jedoch eine gegenüber einem konventionellen EDAS-Design zusätzliche Asymmetrie bezüglich der Dicken der ersten Zwischenschicht 11 (GRIN-Schicht) und der zweiten Zwischenschicht 15 (GRIN-Schicht) realisiert. Während der Aufbau der zweiten Zwischenschicht 15 im p-seitigen Bereich weitgehend dem konventionellen EDAS-Design entspricht, wurde die Dicke der ersten Zwischenschicht 11 in Bezug zur Dicke der zweiten Zwischenschicht 15 deutlich erhöht. Dies bedeutet, dass die aktive Schicht 10 bei ETAS-Design nicht mehr mittig zwischen den eingezeichneten Grenzflächen der ersten Zwischenschicht 11 mit der ersten Wellenleiterschicht 12 und der zweiten Zwischenschicht 15 mit der zweiten Wellenleiterschicht 16 angeordnet ist. Insbesondere ist in der Darstellung das Asymmetrie-Verhältnis aus der Dicke der ersten Zwischenschicht 11 zur Summe aus der Dicke der ersten Zwischenschicht 11 und der Dicke der zweiten Zwischenschicht 15 größer als 0,5.

Das Maximum der Intensität der eingezeichneten Grundmode wandert bei dem dargestellten ETAS-Design deutlich in Richtung der aktiven Schicht 10 (d.h. hoher Modeneinschluss). Insbesondere zeigt die Darstellung, dass ein Großteil der Modenintensität innerhalb der ersten Zwischenschicht 11 lokalisiert ist. Gegenüber der Darstellung in Fig. 1 weist das gezeigte Modenprofil eine geringere Modenausdehnung (geringeres Modenvolumen) und eine höhere räumliche Überlappung mit der aktiven Schicht 10 bei einer gesteigerten Maximalintensität im Maximum der Mode auf. Die Mode kann daher auch wesentlich stärker mit der aktiven Schicht 10 wechselwirken. Der Modeneinschluss ist deutlich erhöht.

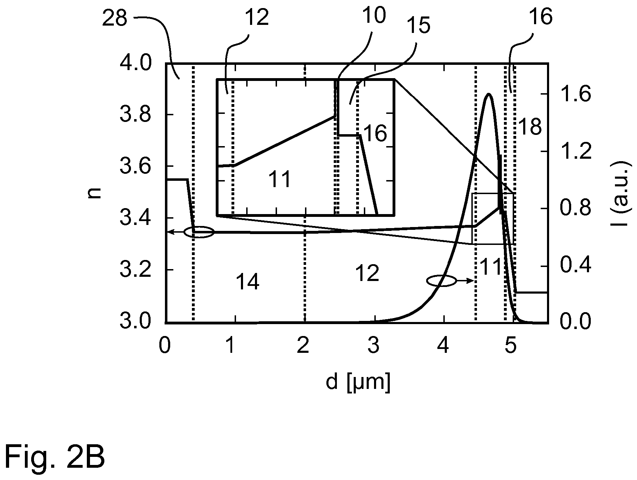

Fig. 2B zeigt die Brechzahlverteilung entlang der Schichten einer zweiten Ausführungsform einer erfindungsgemäßen ETAS-Laserdiode sowie die dazugehörige vertikale Verteilung der Modenintensität in der Laserdiode. Die Darstellung entspricht im Wesentlichen der in Fig. 2B gezeigten Darstellung. Die jeweiligen Bezugszeichen gelten entsprechend. Bei der dargestellten Ausführungsform handelt es sich im Unterschied zur ersten Ausführungsform nach Fig. 2A bei der p-leitenden zweiten Zwischenschicht 15 um eine Schicht mit konstanter Brechzahl. Die n-leitende erste Zwischenschicht 11 ist hingegen als GRIN-Schicht ausgeführt.

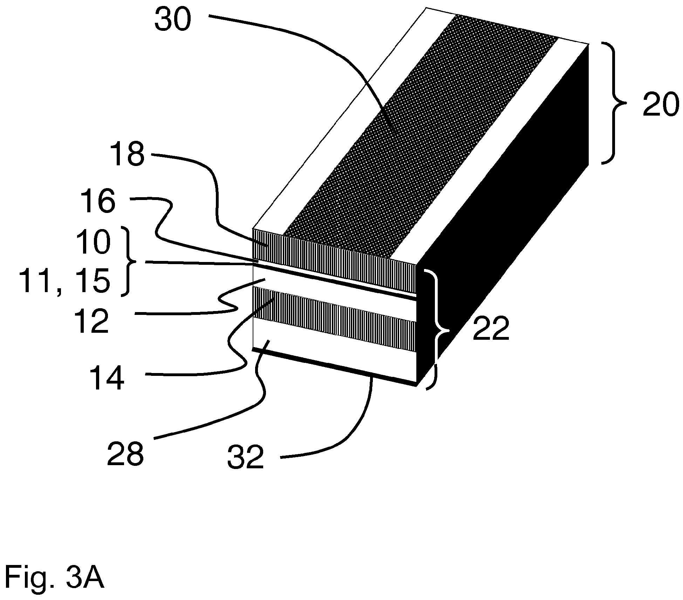

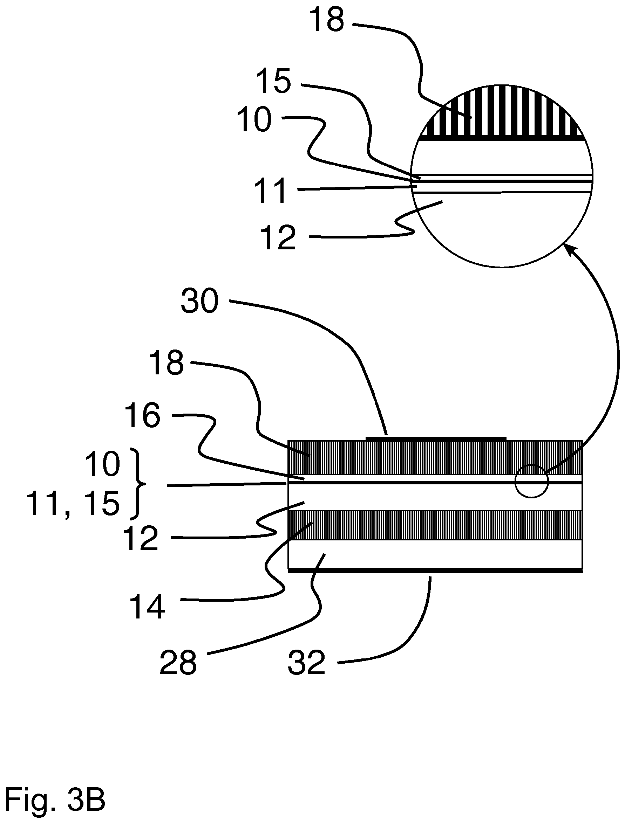

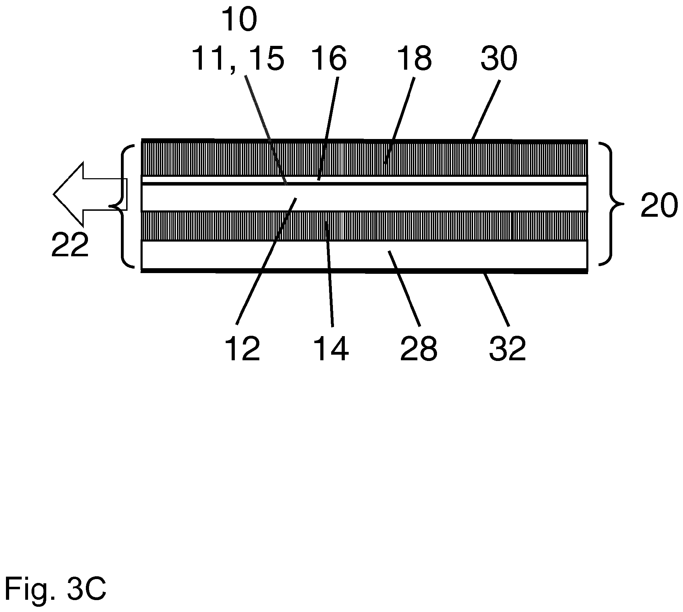

Fig. 3A-3C zeigen eine erfindungsgemäße Laserdiode in perspektivischer und geschnittener Darstellung. Die erfindungsgemäße Laserdiode weist einen vertikalen Schichtaufbau mit einem Substrat 28, einer darauf angeordneten n-leitenden erste Mantelschicht 14, einer darauf angeordneten n-leitenden ersten Wellenleiterschicht 12, einer darauf angeordneten n-leitenden ersten Zwischenschicht 11, einer darauf angeordneten aktiven Schicht 10, einer darauf angeordneten p-leitenden zweiten Zwischenschicht 15, einer darauf angeordneten p-leitenden zweiten Wellenleiterschicht 16 und einer darauf angeordneten p-leitenden zweiten Mantelschicht 18 auf. Beispielhaft sind weiterhin ein erster Kontakt zur Injektion von Ladungsträgern 30 und ein zweiter Kontakt zur Injektion von Ladungsträgern 32 eingezeichnet. Die genaue Lage der ersten Zwischenschicht 11, der zweiten Zwischenschicht 15 und der aktiven Schicht 10 kann der vergrößerten Darstellung in Fig. 3B entnommen werden.

Weiterhin weist die erfindungsgemäße Laserdiode an den seitlichen gegenüberliegenden Enden eine Reflexionsfacette 20 mit einer hohen Reflektivität für die Zentralwellenlänge der von der aktiven Schicht 10 emittieren Strahlung und eine Austrittsfacette 22 mit einer Reflektivität, die eine Auskopplung der Strahlung ermöglicht, auf. Die Reflektivität der Reflexionsfacette 20 beträgt vorzugsweise größer 0,8, bevorzugter größer 0,9 und noch bevorzugter größer 0,99. Die Reflektivität der Austrittsfacette 22 ist vorzugsweise kleiner als die Reflektivität der Reflexionsfacette 20. Die Facetten 20 und 22 bilden eine Kavität, so dass ein Laserbetrieb erreicht werden kann.

Die konkrete Struktur des in den Fig. 3A-3C gezeigten bevorzugten Ausführungsbeispiels ist ein Diodenlaser mit einer aktiven Schicht 10 mit einer zentralen Emissionswellenlänge bei 940 nm, hergestellt aus einem InGaAs Quantenfilm mit einer Dicke von 5,4 nm. Mantel-, Wellenleiter- und Zwischenschichten 11, 12, 14, 15, 16, 18 sind aus AlₓGa₁₋ₓAs hergestellt. Für die Wellenleiter 12 bzw. 16 ist der molare Al-Anteil x in AlₓGa₁₋ₓAs bevorzugt 26% bzw. 25%. Für die Mantelschichten 14 bzw. 18 ist der molare Al-Anteil x in AlₓGa₁₋ₓAs bevorzugt 30% bzw. 70%. Für die Zwischenschichten 11, 15 (GRIN-Schichten) ist der molare Al-Anteil x in AlₓGa₁₋ₓAs an der jeweiligen Grenzfläche zur aktiven Schicht 10 bevorzugt 15%. Im bevorzugten Ausführungsbeispiel betragen die Schichtdicke der n-leitenden ersten Mantelschicht 14 1,65 µm, die Schichtdicke der n-leitenden ersten Wellenleiterschicht 12 2,5 µm, die Schichtdicke der n-leitenden ersten Zwischenschicht 11 350 nm, die Schichtdicke der p-leitenden zweiten Zwischenschicht 15 70 nm, die Schichtdicke der p-leitenden zweiten Wellenleiterschicht 16 150 nm und die Schichtdicke der p-leitenden zweiten Mantelschicht 18 800 nm.

In einer alternativen bevorzugten Ausführungsvariante weisen die erste Wellenleiterschicht 12 und die zweite Wellenleiterschicht 16 einen Brechzahlgradienten (durch Variation des Aluminiumgehalts entlang der Schichtdicke) auf, wobei der Aluminiumgehalt bei der zweiten Wellenleiterschicht 16 zwischen 25% und 70% und bei der ersten Wellenleiterschicht 12 zwischen 26% und 30% variiert wird.

Fig. 4 zeigt die simulierten Abhängigkeiten des Modeneinschlusses (a, c) und des vertikalen Fernfeldes (b, d) von der Stärke des Asymmetrie-Verhältnisses und der Schichtdicke der zweiten Wellenleiterschicht. Mantel-, Wellenleiter- und Zwischenschichten 11, 12, 14, 15, 16, 18 sind aus AlₓGa₁₋ₓAs bestehend angenommen, wobei die Schichtdicke der p-leitenden zweiten Wellenleiterschicht 16 70 nm (a, b) bzw. 150 nm (c, d) beträgt. Die Werte für eine in Fig. 1 gezeigte Struktur entsprechend dem Stand der Technik sind dabei in Fig. 4 (a, b) jeweils mit einem ∘ ("Kreis") gekennzeichnet, während die Werte für eine erfindungsgemäße Struktur entsprechend der ersten Ausführungsvariante nach Fig. 2 mit einem □ ("Quadrat)"gekennzeichnet sind. Alle weiteren Angaben zu den Simulationsparametern können der Beschreibung zu der in den Fig. 3A-3C dargestellten erfindungsgemäßen Laserdiode entnommen werden.

Die Simulation wurde für verschiedene Dicken der p-leitenden zweiten Zwischenschicht 15 (70 nm (a, b), 150 nm (c, d) unter Veränderung der Dicke der n-leitenden ersten Zwischenschicht 11 (10 nm - 350 nm) bei verschiedenen molaren Al-Anteilen x an der Grenzfläche zwischen der n-leitenden ersten Zwischenschicht 11 und der ersten Wellenleiterschicht 12 untersucht. Der molare Al-Anteil x an der Grenzfläche zwischen der p-leitenden zweiten Zwischenschicht 15 und der zweiten Wellenleiterschicht 16 beträgt konsistent 25% (bzw. 0,25). Die aktive Schicht besteht aus einem Quantenfilm mit einer Dicke von 5,4 nm. Die Kreise in den Diagrammen a), b) korrespondieren zu der in Fig. 1 gezeigten Vertikalstruktur einer herkömmlichen EDAS-Laserdiode. Die Quadrate in den Diagrammen a), b) korrespondieren zu der in Fig. 2 gezeigten Vertikalstruktur einer erfindungsgemäß erweiterten EDAS-Laserdiode mit einer zusätzlichen Asymmetrie-Komponente im Bereich der aktiven Schicht 10 (ETAS-Laserdiode).

Fig. 5 zeigt die Leistungs-Spannungs-Strom-Charakteristik dreier vergleichbarer Halbleiterlaserdioden mit verschiedenen Ausführungsformen eines erfindungsgemäßen ETAS-Designs bei 25°C (a) und bei 75°C (b). Bei den einzelnen ETAS-Laserdioden wurde erfindungsgemäß der Modeneinschluss über das Asymmetrie-Verhältnis variiert. Es handelt es sich hierbei um Breitsteifen-Halbleiterlaser für den Hochleistungsbetrieb (Pₒᵤₜ > 15 W). Wird ein solcher Halbleiterlaser mit einer Konversionseffizienz von 55% am Arbeitspunkt von 15 W betrieben, wobei eine Kühlung mit einem industriell üblichen passiven Kühlsystem mit einer Kühlmitteltemperatur von 25°C erfolgt, so lässt sich bei einem mittleren thermischen Widerstand von 3 K/W die Temperatur der aktiven Zone mit ca. 62°C annehmen.

Werden nun die Kennlinien der drei Laserdioden mit ETAS Design bei 25°C (a) und bei 75°C (b) ausgewertet, so zeigen sich deutliche Unterschiede in der jeweiligen Leistungscharakteristik. Alle drei getesteten Vertikalstrukturen haben einen vergleichbaren p-Schichtaufbau, was daran zu erkennen ist, dass sich die Spannungscharakteristik der drei Dioden nicht wesentlich unterscheidet.

Bei einer Wärmesenkentemperatur von 25°C (a) sind mit Bezug auf den Modeneinschluss keine nennenswerten Leistungssättigungsmechanismen zu erkennen. Der Schwellenstrom ist jedoch höher für Strukturen mit kleinerem Modeneinschluss, was bereits bei Raumtemperatur einen erheblichen Effizienzverlust mit sich bringt. Höhere Schwellenströme führen zu höheren Ladungsträgerdichten innerhalb der aktiven Schicht und im Wellenleiter. Dieser Effekt resultiert in einer erhöhten Photonenabsorption an freien Ladungsträgern und exzessiver Wärmegenerierung, was zu einem selbstverstärkenden Effekt führt. Die Bandkanten in der Nähe des Quantenfilms werden verbogen, sodass sich die Leckstromraten erhöhen und sich die Ladungsträgerakkumulation im Wellenleiter weiter verstärkt.

Betrachtet man nun dieselben Dioden bei einer erhöhten Wärmesenkentemperatur am Betriebspunkt von 75°C (b), so fällt auf, dass sich die genannten vom Modeneinschluss und vom Strom abhängigen Sättigungsmechanismen einschalten. Es ist hieraus zu erkennen, dass es für den Hochleistungsbetrieb bei hohen Betriebstemperaturen besonders bevorzugt ist, einen großen Modeneinschluss anzustreben um die Ladungsträgerdichten zu verringern, wobei der p-Wellenleiter so schmal wie möglich gehalten werden sollte.

### Bezugszeichenliste

- 10: Aktive Schicht
- 11: Erste Zwischenschicht (n-leitend)
- 12: Erste Wellenleiterschicht (n-leitend)
- 14: Erste Mantelschicht (n-leitend)
- 15: Zweite Zwischenschicht (p-leitend)
- 16: Zweite Wellenleiterschicht (p-leitend)
- 18: Zweite Mantelschicht (p-leitend)
- 20: Reflexionsfacette
- 22: Austrittsfacette
- 28: Substrat
- 30: erster Kontakt zur Injektion von Ladungsträgern
- 32: zweiter Kontakt zur Injektion von Ladungsträgern

- x: molarer Al-Gehalt (AlₓGa₁₋ₓAs)
- Γ: Modeneinschluss

## Patentansprüche

1. Diodenlaser, aufweisend:
a) eine n-leitend ausgebildete erste Mantelschicht (14),
b) eine n-leitend ausgebildete erste Wellenleiterschicht (12), die auf der ersten Mantelschicht (14) angeordnet ist,
c) eine aktive Schicht (10), die zur Strahlungserzeugung geeignet ist und die auf der ersten Wellenleiterschicht (12) angeordnet ist,
d) eine p-leitend ausgebildete zweite Wellenleiterschicht (16), die auf der aktiven Schicht (10) angeordnet ist,
e) eine p-leitend ausgebildete zweite Mantelschicht (18), die auf der zweiten Wellenleiterschicht (16) angeordnet ist,
f) wobei zwischen der ersten Wellenleiterschicht (12) und der aktiven Schicht (10) eine n-leitend ausgebildete erste Zwischenschicht (11) als Übergangsbereich ausgebildet ist, und
g) zwischen der zweiten Wellenleiterschicht (16) und der aktiven Schicht (10) eine p-leitend ausgebildete zweite Zwischenschicht (15) als Übergangsbereich ausgebildet ist,
h) wobei die Grenzen zwischen den einzelnen Schichten dadurch bestimmt sind, dass an diesen Stellen der Brechzahlverlauf eine Knickstelle aufweist,
i) wobei es sich bei der ersten Zwischenschicht (11) und, optional, der zweiten Zwischenschicht (15) um eine Gradientenindexschicht mit einem stetigen Brechzahlverlauf handelt,
j) wobei eine maximale Brechzahl der ersten Mantelschicht (14) geringer als eine minimale Brechzahl der erste Wellenleiterschicht (12), eine maximale Brechzahl der erste Wellenleiterschicht (12) geringer als eine minimale Brechzahl der ersten Zwischenschicht (11), eine maximale Brechzahl der ersten Zwischenschicht (11) geringer als eine minimale Brechzahl der aktiven Schicht (10), eine minimale Brechzahl der aktiven Schicht (10) höher als eine maximale Brechzahl der zweiten Zwischenschicht (15), eine minimale Brechzahl der zweiten Zwischenschicht (15) höher als eine maximale Brechzahl der zweiten Wellenleiterschicht (16) und eine minimale Brechzahl der zweiten Wellenleiterschicht (16) höher als eine maximale Brechzahl der zweiten Mantelschicht (18) ist,
k) wobei die Summe der Schichtdicke der ersten Wellenleiterschicht (12) und der Schichtdicke der zweiten Wellenleiterschicht (16) größer als 1 µm ist, wobei die Schichtdicke der zweiten Wellenleiterschicht (16) kleiner als 350 nm ist, und
l) wobei die Differenz der maximalen Brechzahl der ersten Wellenleiterschicht (12) und der Brechzahl der ersten Mantelschicht (14) zwischen 0,04 und 0,01 beträgt,
**dadurch gekennzeichnet, dass**
m) ein Asymmetrie-Verhältnis aus der Dicke der ersten Zwischenschicht (11) zur Summe aus der Dicke der ersten Zwischenschicht (11) und der Dicke der zweiten Zwischenschicht (15) von größer als 0,5 derart gewählt ist, dass das Maximum der Modenintensität einer geführten Grundmode innerhalb der ersten Zwischenschicht (11) lokalisiert ist.

2. Diodenlaser nach einem der vorhergehenden Ansprüche, wobei die Schichtdicke der zweiten Wellenleiterschicht (16) kleiner als 150 nm ist.

3. Diodenlaser nach einem der vorhergehenden Ansprüche, wobei die Schichtdicke der ersten Zwischenschicht (11) und die Schichtdicke der zweiten Zwischenschicht (15) kleiner als 350 nm ist.

4. Diodenlaser nach einem der vorhergehenden Ansprüche, wobei innerhalb der ersten Zwischenschicht (11) die Brechzahl, von der aktiven Schicht (10) ausgehend, in Richtung der ersten Wellenleiterschicht (12) um mindestens 0,03 oder um 30% der Differenz zwischen der maximalen Brechzahl der ersten Zwischenschicht (10) und der minimalen Brechzahl der ersten Wellenleiterschicht (12) abfällt.

5. Diodenlaser nach einem der vorhergehenden Ansprüche, wobei die aktive Schicht (10) eine Schichtdicke kleiner als 80 nm aufweist.

6. Diodenlaser nach einem der vorhergehenden Ansprüche, wobei die aktive Schicht (10) mindestens einen Quantentopf aufweist.

7. Diodenlaser nach einem der vorhergehenden Ansprüche, wobei die erste Zwischenschicht (11) und die zweiten Zwischenschicht (15) aus AlₓGa₁₋ₓAs bestehen.

8. Diodenlaser nach Anspruch 7, wobei der molare Al-Gehalt (x) der ersten Zwischenschicht (11) an der Grenzfläche zwischen der ersten Zwischenschicht (11) und der aktiven Schicht (10) größer als 0 ist.

9. Diodenlaser nach Anspruch 7 oder 8, wobei der molare Al-Gehalt (x) der ersten Zwischenschicht (11) an der Grenzfläche zwischen der ersten Wellenleiterschicht (12) und der ersten Zwischenschicht (11) größer als 0,05 ist.

10. Diodenlaser nach einem der vorhergehenden Ansprüche, wobei mindestens eine der Wellenleiterschichten (12, 16) einen Brechzahlgradienten aufweist.

11. Diodenlaser nach einem der vorhergehenden Ansprüche, wobei der Diodenlaser als kantenemittierender Diodenlaser oder als optischer Verstärker ausgebildet ist.

## Claims

1. A diode laser, comprising:
a) an n-type first cladding layer (14),
b) an n-type first waveguide layer (12) arranged on the first cladding layer (14),
c) an active layer (10) suitable for radiation generation and arranged on the first waveguide layer (12),
d) a p-type second waveguide layer (16) arranged on the active layer (10),
e) a p-type second cladding layer (18) arranged on the second waveguide layer (16),
f) wherein an n-type first intermediate layer (11) is formed as a transition region between the first waveguide layer (12) and the active layer (10), and
g) a p-type second intermediate layer (15) is formed as a transition region between the second waveguide layer (16) and the active layer (10),
h) wherein boundaries between the individual layers are determined by a fact that a refractive index curve at these locations has a kink,
i) wherein the first intermediate layer (11) and, optionally, the second intermediate layer (15) are gradient index layers with a continuous refractive index curve,
j) wherein a maximum refractive index of the first cladding layer (14) is less than a minimum refractive index of the first waveguide layer (12), a maximum refractive index of the first waveguide layer (12) is less than a minimum refractive index of the first intermediate layer (11), a maximum refractive index of the first intermediate layer (11) is less than a minimum refractive index of the active layer (10), the minimum refractive index of the active layer (10) is higher than a maximum refractive index of the second intermediate layer (15), a minimum refractive index of the second intermediate layer (15) is higher than a maximum refractive index of the second waveguide layer (16), and a minimum refractive index of the second waveguide layer (16) is higher than a maximum refractive index of the second cladding layer (18),
k) wherein a sum of a layer thickness of the first waveguide layer (12) and a layer thickness of the second waveguide layer (16) is greater than 1 µm, wherein the layer thickness of the second waveguide layer (16) is less than 350 nm, and
l) wherein a difference between the maximum refractive index of the first waveguide layer (12) and a refractive index of the first cladding layer (14) is between 0.04 and 0.01,
**characterized in that**
m) an asymmetry ratio of a layer thickness of the first intermediate layer (11) to a sum of a layer thickness of the first intermediate layer (11) and a layer thickness of the second intermediate layer (15) is selected to be greater than 0.5 such that a maximum mode intensity of a guided fundamental mode is located within the first intermediate layer (11).

2. The diode laser according to any one of the preceding claims, wherein the layer thickness of the second waveguide layer (16) is less than 150 nm.

3. The diode laser according to any one of the preceding claims, wherein the layer thickness of the first intermediate layer (11) and the layer thickness of the second intermediate layer (15) are less than 350 nm.

4. The diode laser according to any one of the preceding claims, wherein within the first intermediate layer (11), a refractive index, starting from the active layer (10), decreases in a direction of the first waveguide layer (12) by at least 0.03 or by 30% of a difference between the maximum refractive index of the first intermediate layer (10) and the minimum refractive index of the first waveguide layer (12).

5. The diode laser according to any one of the preceding claims, wherein the active layer (10) has a layer thickness of less than 80 nm.

6. The diode laser according to any one of the preceding claims, wherein the active layer (10) has at least one quantum well.

7. The diode laser according to any one of the preceding claims, wherein the first intermediate layer (11) and the second intermediate layer (15) consist of AlₓGa₁₋ₓAs.

8. The diode laser according to claim 7, wherein a molar Al content (x) of the first intermediate layer (11) at an interface between the first intermediate layer (11) and the active layer (10) is greater than 0.

9. The diode laser according to claim 7 or 8, wherein a molar Al content (x) of the first intermediate layer (11) at an interface between the first waveguide layer (12) and the first intermediate layer (11) is greater than 0.05.

10. The diode laser according to any one of the preceding claims, wherein at least one of the waveguide layers (12, 16) has a refractive index gradient.

11. The diode laser according to any one of the preceding claims, wherein the diode laser is configured as an edge-emitting diode laser or as an optical amplifier.

## Revendications

1. Diode laser, comprenant:
a) une première couche de gaine (14) de type n,
b) une première couche de guide d'ondes (12) de type n, disposée sur la première couche de gaine (14),
c) une couche active (10) apte à générer un rayonnement, disposée sur la première couche de guide d'ondes (12),
d) une deuxième couche de guide d'ondes (16) de type p, disposée sur la couche active (10),
e) une deuxième couche de gaine (18) de type p, disposée sur la deuxième couche de guide d'ondes (16),
f) dans laquelle, est disposée une première couche intermédiaire (11) de type n et constituant une zone de transition entre la première couche de guide d'onde (12) et la couche active (10), et
g) entre la deuxième couche de guide d'ondes (16) et la couche active (10), une deuxième couche intermédiaire (15) de type p, constituant une zone de transition,
h) dans laquelle les limites entre les différentes couches sont définies de telle sorte que le profil de l'indice de réfraction présente, à ces endroits, une discontinuité,
i) dans laquelle la première couche intermédiaire (11) et, éventuellement, la deuxième couche intermédiaire (15) sont constituées d'une couche à indice de gradient, présentant un profil d'indice de réfraction continu,
j) dans laquelle la valeur maximale de l'indice de réfraction de la première couche de gaine (14) est inférieure à la valeur minimale de l'indice de réfraction de la première couche de guide d'ondes (12), la valeur maximale de l'indice de réfraction de la première couche de guide d'ondes (12) est inférieure à la valeur minimale de l'indice de réfraction de la première couche intermédiaire (11), la valeur maximale de l'indice de réfraction de la première couche intermédiaire (11) est inférieure à la valeur minimale de l'indice de réfraction de la couche active (10), la valeur minimale de l'indice de réfraction de la couche active (10) est supérieure à la valeur maximale de l'indice de réfraction de la deuxième couche intermédiaire (15), la valeur minimale de l'indice de réfraction de la deuxième couche intermédiaire (15) est supérieure à la valeur maximale de l'indice de réfraction de la deuxième couche de guide d'ondes (16), et la valeur minimale de l'indice de réfraction de la deuxième couche de guide d'ondes (16) est supérieure à la valeur maximale de l'indice de réfraction de la deuxième couche de gaine (18),
k) dans laquelle la somme de l'épaisseur de la première couche de guide d'ondes (12) et de l'épaisseur de la deuxième couche de guide d'ondes (16) est supérieure à 1 µm, l'épaisseur de la deuxième couche de guide d'ondes (16) étant inférieure à 350 nm, et
l) dans laquelle la différence entre la valeur maximale de l'indice de réfraction de la première couche de guide d'ondes (12) et l'indice de réfraction de la première couche de gaine (14) est comprise entre 0,04 et 0,01,
**caractérisée en ce que**
m) un rapport d'asymétrie, défini par le rapport de l'épaisseur de la première couche intermédiaire (11) sur la somme de l'épaisseur de la première couche intermédiaire (11) et de l'épaisseur de la deuxième couche intermédiaire (15), est choisi supérieur à 0,5, de telle manière que le maximum de l'intensité des modes d'une mode fondamentale guidée soit localisé à l'intérieur de la première couche intermédiaire (11).

2. Diode laser selon l'une quelconque des revendications précédentes, dans laquelle l'épaisseur de la deuxième couche de guide d'ondes (16) est inférieure à 150 nm.

3. Diode laser selon l'une quelconque des revendications précédentes, dans laquelle l'épaisseur de la première couche intermédiaire (11) et l'épaisseur de la deuxième couche intermédiaire (15) sont inférieures à 350 nm.

4. Diode laser selon l'une quelconque des revendications précédentes, dans laquelle l'intérieur de la première couche intermédiaire (11), l'indice de réfraction, à partir de la couche active (10) en direction de la première couche de guide d'onde (12), diminue d'au moins 0,03 ou de 30 % de la différence entre l'indice de réfraction maximal de la première couche intermédiaire (10) et l'indice de réfraction minimal de la première couche de guide d'onde (12).

5. Diode laser selon l'une quelconque des revendications précédentes, dans laquelle la couche active (10) présente une épaisseur inférieure à 80 nm.

6. Diode laser selon l'une quelconque des revendications précédentes, dans laquelle la couche active (10) comprend au moins un puits quantique.

7. Diode laser selon l'une quelconque des revendications précédentes, dans laquelle la première couche intermédiaire (11) et la deuxième couche intermédiaire (15) sont constituées d'AlₓGa₁₋ₓAs.

8. Diode laser selon la revendication 7, dans laquelle la teneur molaire en Al (x) de la première couche intermédiaire (11), à l'interface entre la première couche intermédiaire (11) et la couche active (10), est supérieure à 0.

9. Diode laser selon la revendication 7 ou 8, dans laquelle la teneur molaire en Al (x) de la première couche intermédiaire (11), à l'interface entre la première couche de guide d'ondes (12) et la première couche intermédiaire (11), est supérieure à 0,05.

10. Diode laser selon l'une quelconque des revendications précédentes, dans laquelle au moins une des couches de guide d'ondes (12, 16) présente un gradient d'indice de réfraction.

11. Diode laser selon l'une quelconque des revendications précédentes, dans laquelle la diode laser est conçue comme une diode laser à émission par la tranche ou comme un amplificateur optique.
